## Europäisches Patentamt
## European Patent Office
## Office européen des brevets

(11) Veröffentlichungsnummer: **0 110 424**
**B1**

(12) **EUROPÄISCHE PATENTSCHRIFT**

(45) Veröffentlichungstag der Patentschrift:
09.03.88

(51) Int. Cl.⁴: **H 05 K 5/04**

(21) Anmeldenummer: **83112158.7**

(22) Anmeldetag: **02.12.83**

(54) **Gehäuse für elektrotechnische Geräte.**

(30) Priorität: **06.12.82 DE 8234235 U**
**06.12.82 DE 8234201 U**

(43) Veröffentlichungstag der Anmeldung:
**13.06.84 Patentblatt 84/24**

(45) Bekanntmachung des Hinweises auf die Patenterteilung:
**09.03.88 Patentblatt 88/10**

(84) Benannte Vertragsstaaten:
**DE FR GB**

(56) Entgegenhaltungen:
**DE - A - 1 654 571**
**DE - A - 3 142 882**
**DE - A - 3 242 625**
**US - A - 2 942 749**

(73) Patentinhaber: **Siemens Aktiengesellschaft Berlin und München, Wittelsbacherplatz 2, D-8000 München 2 (DE)**

(72) Erfinder: **Deiretsbacher, Heribald, Ing.grad., Appenzeller Strasse 125, D-8000 München 71 (DE)**
Erfinder: **Fabrytzek, Christian, Ing.grad., Gustav-Meyrink-Strasse 9, D-8000 München 60 (DE)**
Erfinder: **Kreuzholz, Eckart, Ing.-grad., Starnberger Weg 51, D-8031 Gilching (DE)**

## Beschreibung

Die Erfindung bezieht sich auf ein Gehäuse für elektrotechnische Geräte, insbesondere für Magnetbandgeräte, entsprechend dem Oberbegriff des Schutzanspruchs 1.

Es ist bereits allgemein bekannt, ein Gehäuse für ein elektrotechnisches Gerät aus einem Gerüst aufzubauen, an dem Verkleidungsteile befestigt werden. Es wäre denkbar, das Gerüst aus einer Bodenwanne, einem Gehäusedach und zwei Seitenteilen aufzubauen und an dieses Gerüst die Verkleidungsteile anzuschrauben. Ein derartiges Gerüst besteht beispielsweise aus Tiefziehblech und die einzelnen Teile werden unter Verwendung von Schutzgas miteinander verschweisst. Anschliessend wird das Gerüst lackiert und die Verkleidungsteile werden danach an das Gerüst angeschraubt.

Ein derartiges Gehäuse hat eine Vielzahl von Nachteilen. Beispielsweise ist der Schweissvorgang sehr arbeitsintensiv und das Gerüst kann sich durch Wärmespannungen verziehen, so dass es anschliessend ausgerichtet werden muss. Bei der Verwendung von Tiefziehblech ist eine zusätzliche Oberflächenbehandlung, zumindest das Lakkieren erforderlich. Ein weiterer Nachteil eines derartigen Gehäuses ist, dass die Lagerhaltung sehr aufwendig ist, da die Gehäuse im zusammengeschweissten Zustand einen sehr grossen Lagerraum beanspruchen.

Der Erfindung liegt daher die Aufgabe zugrunde, ein Gehäuse für elektrotechnische Geräte anzugeben, das äusserst kostengünstig hergestellt werden kann.

Erfindungsgemäss wird die Aufgabe bei dem Gehäuse der eingangs genannten Art durch die im kennzeichnenden Teil des Patentanspruchs 1 angegebenen Merkmale gelöst.

Das Gehäuse gemäss der Erfindung hat den Vorteil, dass es einen geringen Arbeitsaufwand erfordert, da infolge des Nietvorgangs anstelle des Schweissvorgangs keine Richtarbeit mehr erforderlich ist und da durch die Verwendung des feuerverzinkten Blechs eine zusätzliche Oberflächenbehandlung nicht mehr erforderlich ist. Die Lagerhaltung des Gehäuses wird sehr einfach, da nur noch die Einzelteile sehr raumsparend aufbewahrt werden müssen und die Herstellung des Gerüsts in die Endmontage integrierbar ist. Neben den geringen Lagerkosten treten auch geringe Transportkosten auf, da, wie bereits erwähnt, die eigentlichen Gerüste erst in der Endmontage zusammengebaut werden müssen.

Zur Erhöhung der Stabilität des Gerüsts ist es zweckmässig, wenn das Gerüst mindestens einen Mittelboden enthält, der mit den Seitenteilen vernietet ist. Die Nieten sind zweckmässigerweise als Blindnieten ausgebildet. Zur Befestigung der Verkleidungsteile ist es günstig, wenn diese am Gerüst eingerastet sind. Die Einrastung kann durch allgemein bekannte Kunststoffteile erfolgen.

Eine vorteilhafte Befestigung der Seitenverkleidungen wird erreicht, wenn das Blech der Seitenverkleidungen am unteren Ende eine erste Biegung aufweist, die das Blech nach oben umlenkt und eine zweite Biegung aufweist, die das Blech wieder mindestens teilweise nach unten umlenkt und dass die zweite Biegung über eine Kante der Bodenwanne gehängt ist.

Die erste Biegung wird entweder als Falz ausgebildet oder U-förmig ausgebildet, wobei zwei rechtwinklige Biegungen vorgesehen sein können. Die zweite Biegung ist zweckmässigerweise V-förmig ausgestaltet, wobei eine erste Teilbiegung mit einem rechten Winkel und eine zweite Teilbiegung vorgesehen sein kann, die einen Winkel aufweist, der kleiner als 90° ist. Die Biegungen können mit grosser Präzision durchgeführt werden, so dass spätere Einstellarbeiten nicht erforderlich sind. Zwischen der Seitenverkleidung und der Kante der Bodenwanne kann ein Abstandshalter vorgesehen sein.

Ein Ausführungsbeispiel eines Gehäuses gemäss der Erfindung wird im folgenden anhand von Zeichnungen näher erläutert. Es zeigen

Fig. 1 eine Frontansicht eines Gerüsts,

Fig. 2 eine Seitenansicht des Gerüsts mit auf dem Gehäusedach aufgesetzten Verkleidungsteilen,

Fig. 3 eine denkbare Anordnung zum Befestigen einer Seitenverkleidung,

Fig. 4 eine erste Ausführungsform der Befestigung der Seitenverkleidung,

Fig. 5 eine zweite Ausführungsform der Befestigung der Seitenverkleidung,

Fig. 6 eine dritte Ausführungsform der Befestigung der Seitenverkleidung.

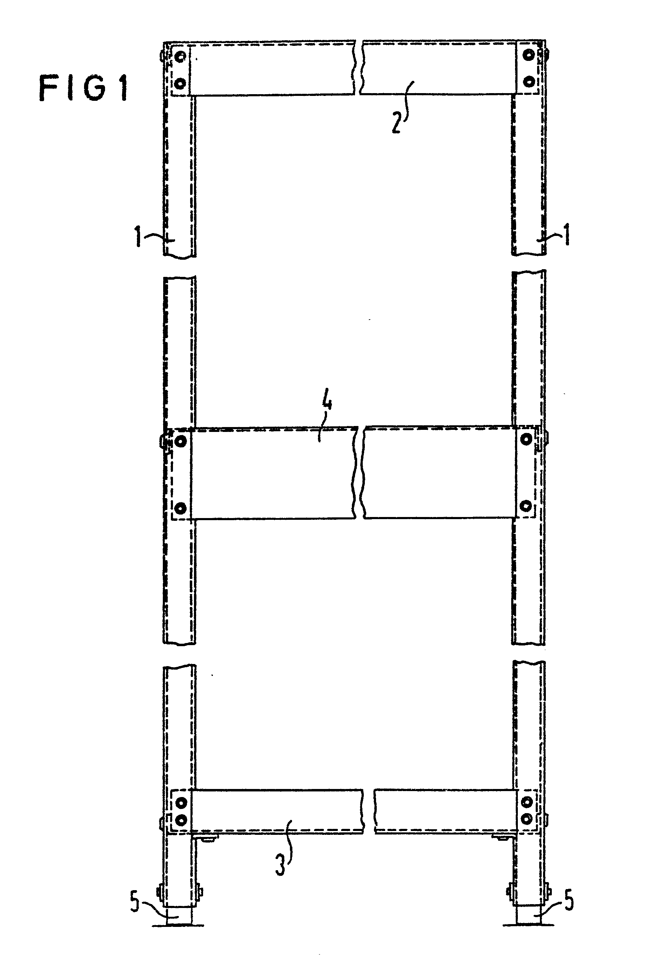

Das in Fig. 1 dargestellte Gerüst des Gehäuses enthält zwei Seitenteile 1, die als Seitenwände ausgebildet sind. Anstelle der beiden Seitenteile 1 können auch vier Eckpfosten vorgesehen sein. Weiterhin enthält das Gerüst ein Oberteil 2, eine Bodenwanne 3 und einen Mittelboden 4. Die Seitenteile 1, das Oberteil 2, die Bodenwanne 3 und der Mittelboden 4 bestehen aus feuerverzinktem Blech mit einer Dicke von beispielsweise 2 mm. Die Seitenteile 1 sind von aussen an das Oberteil 2, die Bodenwanne 3 und an den Mittelboden 4 angenietet. Als Nieten werden vorzugsweise sogenannte Blindnieten verwendet. Die Seitenteile 1 sind unterhalb der Bodenwanne 3 teilweise mit Verlängerungen versehen, in denen Laufrollen 5 drehbar gelagert sind.

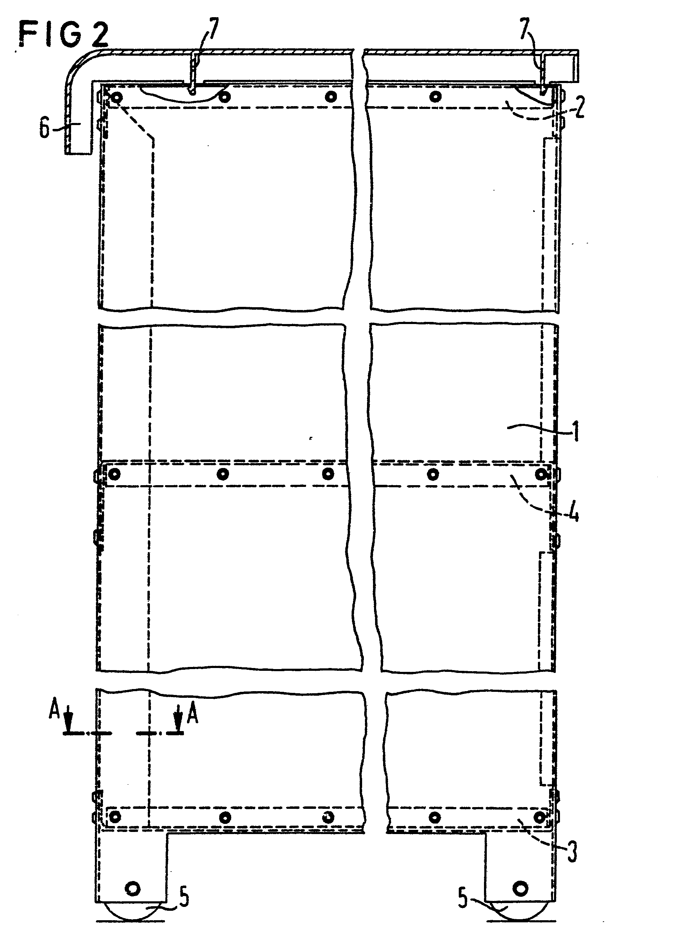

Bei der in Fig. 2 dargestellten Seitenansicht ist das als Seitenwand ausgebildete Seitenteil 1 zu erkennen. das sich über die gesamte Seitenfläche erstreckt. Unterhalb der Bodenwanne 3 sind die Verlängerungen vorgesehen, die die Laufrollen 5 enthalten. An der Oberseite des Gehäuses ist eine Dachverkleidung 6 aus Kunststoff dargestellt, die aus mehreren Teilen bestehen kann. Die Dachverkleidung 6 ist unter Verwendung von Rasthaken 7 am Oberteil 2 eingerastet. Weitere Verkleidungsteile können über den Seitenteilen 1 und an der Vorder- und/oder der Rückseite des Gehäuses angebracht werden.

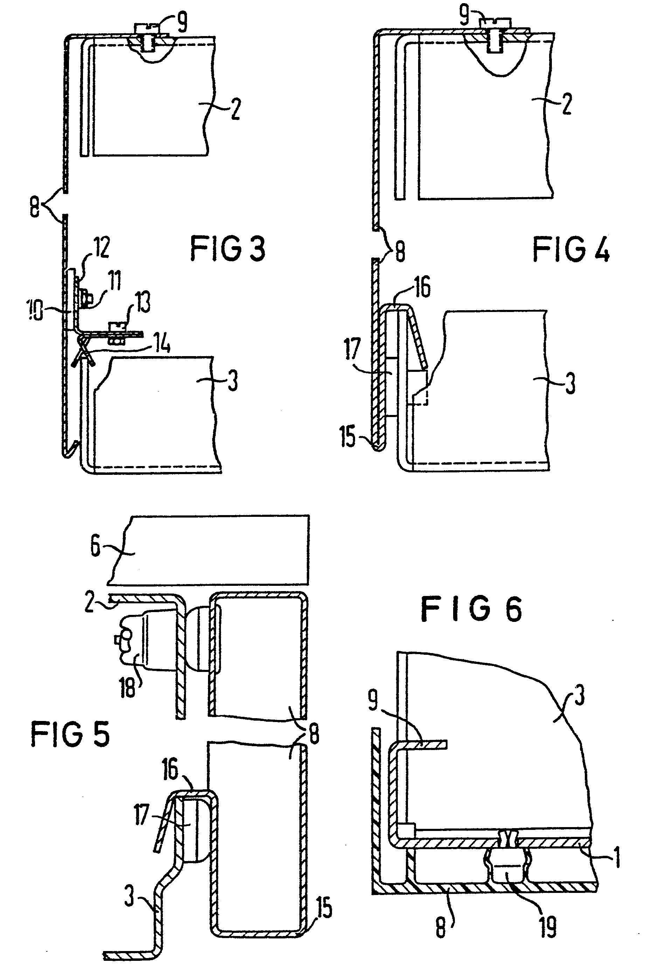

Bei der in Fig. 3 dargestellten denkbaren Anordnung zum Befestigen einer Seitenverkleidung 8 an dem Gehäuse, von dem nur das Oberteil 2 und die Bodenwanne 3 dargestellt sind, wird die Seitenverkleidung 8 über die Bodenwanne 3 gehängt und anschliessend am Oberteil 2 mittels einer Schraube 9 befestigt. Um die Seitenverkleidung 8 über die Bodenwanne 3 hängen zu können, ist am unteren Ende der Seitenverkleidung 8 eine Platte 10 angeschweisst, an der mittels einer Schraubverbindung 11 ein erster Winkel 12 befestigt ist. An diesem ersten Winkel 12 ist mittels einer weiteren Schraubverbindung 13 ein zweiter Winkel 14 befestigt, dessen abstehender Schenkel derart ausgeformt ist, dass er über eine Kante der Bodenwanne 3 gehängt werden kann. Mittels der Schraubverbindungen 11 und 13 sind die Winkel 12 und 14 verschiebbar angeordnet, so dass die Seitenverkleidung 8 in ihrer Einbaulage genau justiert werden kann. Infolge der Mehrzahl von Bauelementen erfordert eine derartige denkbare Anordnung jedoch einen verhältnismässig grossen Aufwand, sowohl an Material als auch an Arbeitszeit.

Bei der in Fig. 4 dargestellten ersten Ausführungsform der Befestigung gemäss der Seitenverkleidung 8 ist die Seitenverkleidung 8 ebenfalls am unteren Ende über eine Kante der Bodenwanne 3 gehängt und am oberen Ende mittels einer Schraube 9 am Oberteil 2 des Gehäuses befestigt. Die Seitenverkleidung 8 besteht ebenfalls aus Blech. Dieses Blech wird mittels einer ersten Biegung 15 wieder nach oben umgelenkt. Diese erste Biegung 15 kann, wie in Fig. 4 dargestellt, als Falz ausgebildet sein. In einer zweiten, V-förmigen Biegung 16 wird das Blech wieder mindestens teilweise nach unten umgelenkt. Diese zweite Biegung 16 kann aus zwei Teilbiegungen bestehen, wobei die erste Teilbiegung einen rechten Winkel und die zweite Teilbiegung einen Winkel aufweist, der kleiner als 90° ist. Mit dieser zweiten Biegung 16 wird die Seitenverkleidung 8 über die Kante der Bodenwanne 3 gehängt. Um die Seitenverkleidung 8 am unteren Ende in horizontaler Richtung zu fixieren, kann an der Bodenwanne 3 oder am unteren Ende der Seitenverkleidung 8 ein Abstandshalter 17 vorgesehen werden, der vorzugsweise aus Kunststoff besteht.

Bei der in Fig. 5 dargestellten zweiten Ausführungsform wird die Seitenverkleidung 8 ebenfalls über eine Kante der Bodenwanne 3 gehängt. Anstelle der Befestigung des oberen Endes der Seitenverkleidung 8 am Oberteil 2 des Gehäuses mittels einer Schraube ist jedoch eine Befestigung mittels eines handelsüblichen Schnellverschlusses 18 vorgesehen, der beispielsweise als handelsüblicher Schnappverschluss ausgebildet ist. In dem dargestellten Ausführungsbeispiel ist die Seitenverkleidung 8 teilweise doppelwandig ausgebildet und wird unter eine Dachverkleidung 6 des Gehäuses geschoben.

Am unteren Ende der Seitenverkleidung 8 ist die erste Biegung 15 U-förmig ausgebildet und besteht aus zwei rechtwinkligen Teilbiegungen. Diese U-förmige erste Biegung 15 ergibt sich zwangsläufig, wenn die Seitenverkleidung 8 doppelwandig ausgebildet ist. Sie kann jedoch auch bei einer Ausführung entsprechend der Darstellung in Fig. 4 vorgesehen werden. Die zweite Biegung 16 ist in ähnlicher Weise ausgeführt wie bei der Darstellung in Fig. 4 und zwischen der Seitenverkleidung 8 und der Bodenwanne 3 ist ebenfalls ein Abstandshalter 17 vorgesehen, dessen Dicke der entsprechenden Dicke des Mittelteils beim Schnellverschluss 18 entspricht.

Die Fig. 6 zeigt ein Schnittbild entsprechend einem Schnitt A–A in Fig. 2, um die Befestigung eines Verkleidungsteils 8 an einem Seitenteil 1 zu zeigen. Das Seitenteil 1 ist von aussen an der Bodenwanne 3 angenietet. Es weist zur Erhöhung der Stabilität eine zusätzliche Biegung 9 auf. Das Verkleidungsteil 8 besteht aus Kunststoff und ist durch Kunststoffnippel 19, wie sie im Automobilbau für die Befestigung von Chromleisten bekannt sind, am Seitenteil 1 verrastet. Zum Zweck der Verrastung ragen Spreizteile der Kunststoffnippel 19 durch entsprechende Bohrungen im Seitenteil 1 hindurch.

**Patentansprüche**

1. Gehäuse für elektrotechnische Geräte, insbesondere Magnetbandgeräte, das aus einem metallischen Gerüst mit einer Bodenwanne, rahmenförmigen Seitenteilen und einem Gehäusedach besteht wobei an dem Gerüst Verkleidungsteile anbringbar sind, dadurch gekennzeichnet, dass die Seitenteile (1), das Gehäusedach (2) und die Bodenwanne (3) aus feuerverzinktem Blech bestehen, dass das Gehäusedach (2) und die Bodenwanne (3) innerhalb der Seitenteile (1) angenietet sind und dass die Verkleidungsteile (6, 8) am Gerüst eingerastet sind.

2. Gehäuse nach Anspruch 1, dadurch gekennzeichnet, dass mindestens ein Mittelboden (4) vorgesehen ist, der ebenfalls aus feuerverzinktem Blech besteht und mit den Seitenteilen (1) vernietet ist.

3. Gehäuse nach Anspruch 1 oder 2, dadurch gekennzeichnet, dass die Nieten als Blindnieten ausgebildet sind.

4. Gehäuse nach Anspruch 3, dadurch gekennzeichnet, dass die Seitenverkleidungen (8) an den Seitenteilen (1) unter Verwendung von an sich bekannten Kunststoffnippeln (18, 19) eingerastet sind.

5. Gehäuse nach einem der Ansprüche 1 bis 4, dadurch gekennzeichnet, dass das Blech der Seitenverkleidungen (8) am unteren Ende eine erste Biegung (15) aufweist, die das Blech nach oben umlenkt und eine zweite Biegung (16) aufweist, die das Blech wieder mindestens teilweise nach unten umlenkt und dass die zweite Biegung (16) über eine Kante der Bodenwanne (3) gehängt ist.

6. Gehäuse nach Anspruch 5, dadurch gekennzeichnet, dass die erste Biegung (15) als Falz ausgebildet ist.

7. Gehäuse nach Anspruch 6, dadurch gekennzeichnet, dass die erste Biegung (15) U-förmig ausgebildet ist.

8. Gehäuse nach einem der Ansprüche 5 bis 7, dadurch gekennzeichnet, dass die zweite Biegung (16) aus zwei Teilbiegungen gebildet wird, wovon die eine einen rechten Winkel und die andere einen Winkel aufweist, der kleiner als 90° ist.

9. Gehäuse nach einem der Ansprüche 3 bis 8, dadurch gekennzeichnet, dass zwischen der Seitenverkleidung (8) und der Kante der Bodenwanne (3) ein Abstandshalter (17) vorgesehen ist.

## Claims

1. A housing for electro-technical devices, in particular magnetic tape devices, which consists of a metal framework having a base trough, frame-shaped side-pieces and a housing roof, where casing members can be mounted on the framework, characterised in that the side-pieces (1), the housing roof (2), and the base trough (3) are made of hot galvanised sheet metal; that the housing roof (2) and the base trough (3) are riveted in the side-pieces (1); and that the casing members (6, 8) are locked onto the framework.

2. A housing as claimed in Claim 1, characterised in that at least one middle plate (4) is provided, which is also made of hot galvanised sheet metal and riveted onto the side-pieces (1).

3. A housing as claimed in Claim 1 or 2, characterised in that the rivets are in the form of blind rivets.

4. A housing as claimed in Claim 3, characterised in that the side-casing members (8) are locked onto the side-pieces (1) using synthetic resin nipples (18, 19) known per se.

5. A housing as claimed in one of Claims 1 to 4, characterised in that the sheet metal of the side-casing members (8) has at the lower end a primary bend (15) which turns the sheet metal upwards and a secondary bend (16) which turns the sheet metal at least partially back downwards; and that the secondary bend (16) is hung over an edge of the base trough (3).

6. A housing as claimed in Claim 5, characterised in that the primary bend (15) is in the form of a fold.

7. A housing as claimed in Claim 6, characterised in that the primary bend (15) is U-shaped.

8. A housing as claimed in one of Claims 5 to 7, characterised in that the secondary bend (16) is formed of two part bends, one of which has a right angle and the other an angle which is smaller than 90°.

9. A housing as claimed in one of Claims 3 to 8, characterised in that a spacer is provided between the side-casing member (8) and the edge of the base trough (3).

## Revendications

1. Boîtier pour appareils électrotechniques, notamment pour des appareils à bande magnétique, qui est constitué par une ossature métallique munie d'un fond en forme de cuvette, par des parties latérales en forme de cadres et par un toit, et dans lequel des éléments d'habillage peuvent être installés sur l'ossature, caractérisé par le fait que les éléments latéraux (1), le toit (2) du boîtier et le fond en forme de cuvette (3) sont constitués par de la tôle galvanisée à chaud, que le toit (2) du boîtier et le fond en forme de cuvette (3) sont fixés par rivetage à l'intérieur des éléments latéraux (1) et que les éléments d'habillage (6, 8) sont fixés par encliquetage sur l'ossature.

2. Boîtier suivant la revendication 1, caractérisé par le fait qu'il est prévu au moins un fond intermédiaire (4) qui est également constitué par une tôle galvanisée à chaud et est fixé par rivetage aux éléments latéraux (1).

3. Boîtier suivant la revendication 1 ou 2, caractérisé par le fait que les rivets sont réalisés sous la forme de rivets borgnes.

4. Boîtier suivant la revendication 3, caractérisé par le fait que les éléments d'habillage latéraux (8) sont fixés par encliquetage aux éléments latéraux (1), moyennant l'utilisation de raccords en matière plastique (18, 19) connus en soi.

5. Boîtier suivant l'une des revendications 1 à 4, caractérisé par le fait que la tôle des éléments d'habillage latéraux (8) comporte, au niveau de son extrémité inférieure, un premier pliage (15), dans lequel la tôle est rabattue vers le haut, et un second pliage (16), dans lequel la tôle est à nouveau rabattue au moins partiellement vers le bas, et que le second pliage (16) est accroché par dessus un bord du fond en forme de cuvette (3).

6. Boîtier suivant la revendication 5, caractérisé par le fait que le premier pliage (15) est réalisé sous la forme d'un pli.

7. Boîtier suivant la revendication 6, caractérisé par le fait que le premier pliage (15) est réalisé avec la forme d'un U.

8. Boîtier suivant l'une des revendications 5 à 7, caractérisé par le fait que le second pliage (16) est formé de deux pliages partiels, dont l'un fait un angle droit et dont l'angle fait un angle inférieur à 90°.

9. Boîtier suivant l'une des revendications 3 à 8, caractérisé par le fait qu'une entretoise (17) est prévue entre l'élément d'habillage (8) et le bord du fond en forme de cuvette (3).

FIG 1

FIG 2

FIG 3

FIG 4

FIG 5

F I G 6